(19) Europäisches Patentamt
European Patent Office
Office européen des brevets

(11) **EP 2 484 011 B1**

(12) **FASCICULE DE BREVET EUROPEEN**

(45) Date de publication et mention
de la délivrance du brevet:
**07.08.2013 Bulletin 2013/32**

(51) Int Cl.:
*H03K 5/08* *(2006.01)*  *H03K 5/04* *(2006.01)*
*G01T 1/17* *(2006.01)*

(21) Numéro de dépôt: **10759675.1**

(22) Date de dépôt: **30.09.2010**

(86) Numéro de dépôt international:
**PCT/EP2010/064569**

(87) Numéro de publication internationale:
**WO 2011/039312 (07.04.2011 Gazette 2011/14)**

(54) **DISPOSITIF DE TRAITEMENT D'UN SIGNAL DELIVRÉ PAR UN DETECTEUR DE RAYONNEMENT**

GERÄT ZUR VERARBEITUNG EINES SIGNALS AUS EINEM STRAHLENDETEKTOR

DEVICE FOR THE PROCESSING OF A SIGNAL GENERATED BY A RADIATION DETECTOR

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **01.10.2009 FR 0956844**
**30.11.2009 FR 0958506**

(43) Date de publication de la demande:
**08.08.2012 Bulletin 2012/32**

(73) Titulaire: **Commissariat à l'Énergie Atomique et aux Énergies Alternatives**
**75015 Paris (FR)**

(72) Inventeurs:
• **OUVRIER-BUFFET, Patrice**
**F-74410 Saint-jorioz (FR)**
• **BRAMBILLA, Andréa**
**F-38113 Veurey-Voroize (FR)**

(74) Mandataire: **Ilgart, Jean-Christophe et al**
**BREVALEX**
**95 rue d'Amsterdam**
**75378 Paris Cedex 8 (FR)**

(56) Documents cités:
**EP-A1- 2 071 722**   **FR-A1- 2 864 628**
**US-A1- 2003 086 523**

**Description**

Domaine technique et art antérieur

L'invention concerne un dispositif de traitement d'un signal délivré par un détecteur de rayonnement. L'invention concerne également un système de détection de rayonnement qui comprend un détecteur de rayonnement et un dispositif de traitement de signal délivré par le détecteur conforme à l'invention.

L'invention concerne plus particulièrement la détection à température ambiante des rayonnements électromagnétiques ionisants (rayons X, rayons y) à l'aide de semi-conducteurs comme, par exemple, le CdZnTe, le CdTe:Cl, le CdTe :In.

L'utilisation des semi-conducteurs comme détecteurs de rayonnements électromagnétiques ionisants présente de nombreux avantages :

- une conversion directe du rayonnement électromagnétique en signal électrique (alors que la conversion est indirecte [gamma/lumière/charges électriques] lorsqu'on utilise un scintillateur associé à un photomultiplicateur),
- des détecteurs fonctionnant à température ambiante, donc peu encombrants, et un signal électrique élevé permettant d'obtenir d'excellentes résolutions en énergie.

Depuis quelques années, les progrès relatifs à la croissance des matériaux et à la technologie des détecteurs ainsi que les progrès en électronique et traitement du signal ont permis de confirmer les ambitions des semi-conducteurs en spectrométrie de rayonnement électromagnétique ionisant et d'ouvrir largement leurs domaines d'utilisation, à savoir, par exemple : les imageurs 2D pour l'imagerie médicale avec le développement des scanners à base de CdZnTe, les systèmes de contrôle de bagages par rayons X dans le domaine de la sécurité, les sondes nucléaires pour le contrôle d'assemblages irradiés.

Le domaine d'utilisation de la présente invention est, plus particulièrement, mais non exclusivement, celui du contrôle des bagages par imagerie à rayons X, notamment en vue de détecter la présence d'explosifs.

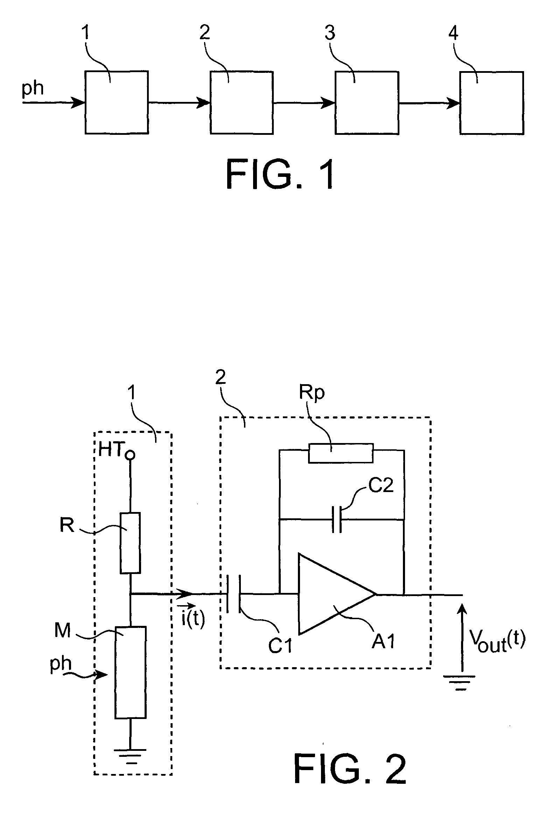

Un synoptique de système de détection de rayonnements électromagnétiques ionisants est représenté de façon symbolique en figure 1. Le système de détection comprend un détecteur de rayonnement électromagnétique ionisant 1, un circuit électronique de proximité 2 qui mesure le signal délivré par le détecteur 1, un circuit électronique de traitement 3 (filtrage, amplificateur...) qui traite le signal délivré par le circuit électronique 2 et un système électronique 4 qui numérise les signaux délivrés par le circuit électronique 3 afin d'obtenir l' histogramme de ces signaux.

Une spectrométrie de rayonnement électromagnétique consiste ainsi à compter et à mesurer avec la plus grande précision possible (on parle de résolution en énergie) l'énergie de tous les photons qui composent le rayonnement électromagnétique et sont absorbés par le détecteur (on parle d'efficacité de détection).

Selon les domaines d'utilisation, le rayonnement électromagnétique incident est constitué d'un spectre en énergie de photons plus ou moins nombreux avec une gamme en énergies très variable (quelques keV à quelques MeV). Le choix de l'épaisseur et de la surface d'un détecteur à semi-conducteur dépendent respectivement de l'efficacité de détection et de la sensibilité attendue du système. A titre d'exemple non limitatif, une épaisseur inférieure au millimètre suffit à arrêter la plus grande partie des photons de basses énergies (<100 keV), par contre, pour des photons de hautes énergies (>100 keV), une épaisseur de quelques millimètres, voire un centimètre, peut être nécessaire.

Un détecteur d'épaisseur importante permet d'arrêter un maximum de photons (augmentation de la probabilité d'interaction) mais diminue le taux de comptage possible car le temps de transit des charges dans le détecteur est directement proportionnel à son épaisseur. Une tension de polarisation élevée, ainsi que des configurations particulières du détecteur (irradiation par la tranche) permettent alors d'augmenter l'efficacité tout en maintenant un temps de transit faible (impulsions de courant <100 ns).

Comme cela a été mentionné précédemment, un système de spectrométrie de rayonnements électromagnétiques ionisants comprend, outre le détecteur 1, un circuit électronique de proximité 2, un circuit électronique de traitement 3 et un système électronique de numérisation 4.

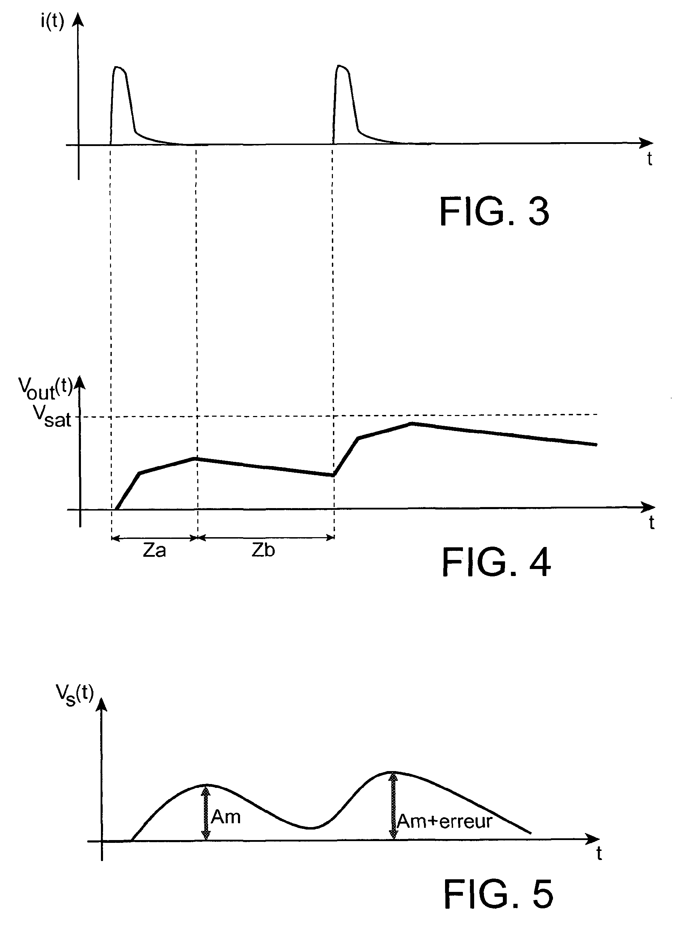

La figure 2 représente un circuit électronique de proximité 2 relié à un détecteur 1. La figure 3 représente le courant i(t) qui est délivré par le détecteur et qui entre dans le circuit électronique 2 et la figure 4 représente la tension $V_{OUT}$(t) délivrée par le circuit électronique 2.

Le détecteur l comprend un bloc de matériau semi-conducteur M et une résistance R qui relie le bloc M à une haute tension HT. Le circuit électronique de proximité 2 est un préamplificateur de charges qui comprend une capacité Cl, un amplificateur Al, une capacité C2 et une résistance Rp. La capacité Cl est montée en entrée de l'amplificateur Al et la capacité C2 et la résistance Rp sont montées en série entre l'entrée et la sortie de l'amplificateur Al.

Lors de la détection de l'interaction d'un photon ph, un courant i(t) peut être collecté par une électrode reliée au détecteur. Pendant le temps de présence du courant détecteur i(t) délivré par le détecteur 1, la tension $V_{OUT}$ (t) en sortie du préamplificateur de charges est :

$$V_{OUT} = -\frac{1}{C2} \int i\, dt,$$

soit

$$V_{OUT} = -\frac{Q}{C2}$$

où Q est la quantité de charges émise par le photon qui interagit dans le matériau semi-conducteur M (cf. zone temporelle Za sur la figure 4).

En sortie du préamplificateur de charges, l'information qui correspond à l'énergie du photon est fugitive car le préamplificateur se décharge. Il faut donc sauvegarder cette tension au plus vite après la disparition du courant détecteur (cf. zone temporelle Zb sur la figure 4). Parallèlement, la relaxation du préamplificateur de charges permet de faire face à de forts taux de comptage car la tension en sortie de celui-ci s'accumule et, sans relaxation, le préamplificateur serait vite saturé (cf. la tension de saturation $V_{sat}$ (sur la figure 4).

La tension $V_{OUT}$(t) délivrée par le circuit électronique 2 est la tension d'entrée d'un circuit électronique de traitement 3. La figure 5 représente la tension Vs (t) que délivre un circuit électronique de traitement 3 en fonction du temps.

Le circuit électronique de traitement 3 comprend un filtre passe-bande qui permet d'optimiser le rapport signal sur bruit. De nombreux filtres d'impulsions peuvent être utilisés filtres à n dérivations et n intégrations, fil très gaussiens, trapézoïdaux, triangulaires, numériques, etc. Ces filtres sont souvent accordables et il est possible de régler les constantes de temps dérivées et intégrales pour ajuster au mieux le rapport signal sur bruit dans la bande d'intérêt. Pour tous ces filtres, le but à atteindre est d'avoir en leurs sorties une impulsion dont l'amplitude est proportionnelle à l'énergie du photon qui interagit dans le détecteur. On constate que les filtres d'impulsion altèrent l'information temporelle correspondant à la durée du courant détecteur, elle est en effet majorée par la dérivation et l'intégration. Cet effet diminue le taux de comptage admissible en augmentant les empilements. On rappelle que le taux de comptage correspond au nombre d'impulsions détectées aux bornes du détecteur par unité de temps.

Quand le taux de comptage est élevé, la tension Vs(t) en sortie du filtre n'a pas assez de temps pour revenir à zéro, l'amplitude de la tension du photon suivant est alors fausse.

Un autre inconvénient important du filtre provient de sa mauvaise linéarité quand il est employé pour des détecteurs qui délivrent des impulsions de courant ayant de grandes variations de formes (détecteurs épais), c'est l'erreur de déficit balistique.

La solution habituelle pour réduire cette erreur consiste à filtrer avec une constante de temps très supérieure à la durée de l'impulsion du courant d'entrée, ce qui est évidemment en conflit avec une mise en forme rapide des impulsions adaptée aux forts taux de comptage.

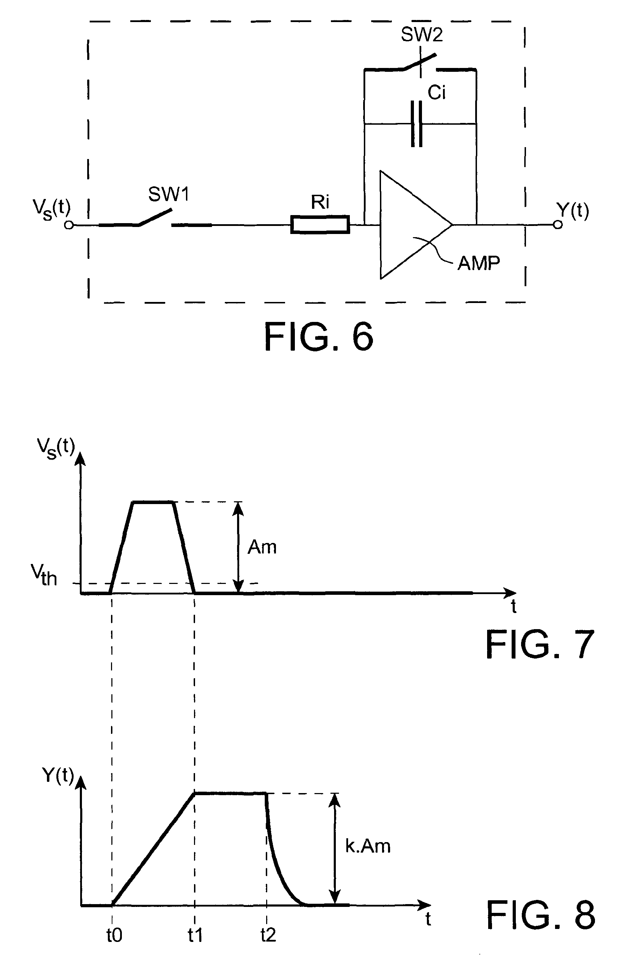

La figure 6 représente un intégrateur commuté apte à mesurer l'énergie des photons détectés, c'est-à-dire l'amplitude des impulsions obtenues en sortie du filtre passe-bande. L'intégrateur comprend un premier interrupteur SWI, une résistance Ri, un amplificateur AMP, un condensateur Ci et un deuxième interrupteur SW2. Le premier interrupteur SWI et la résistance Ri sont montés en série, la résistance Ri étant placée en entrée de l'amplificateur AMP. Le condensateur Ci et le deuxième interrupteur SW2 sont montés en parallèle entre l'entrée et la sortie de l'amplificateur AMP. Les figures 7 et 8 représentent, respectivement, le signal Vs(t) (tension en sortie du filtre) qui entre dans l'intégrateur et le signal y(t) qui sort de l'intégrateur. Le signal entrant Vs (t) a une amplitude Am.

Avant que le signal Vs(t) issu du filtre d'impulsion n'arrive, l'interrupteur SW1 est ouvert et l'interrupteur SW2 est fermé. Dès que le signal Vs(t) franchit une tension de seuil $V_{th}$, l'interrupteur SW2 s'ouvre et l'interrupteur SW1 se ferme. Entre des instants to est t1 le signal Vs(t) est intégré. A partir de l'instant t1, instant de passage seuil sur le front descendant du signal Vs(t), l'interrupteur SW1 s'ouvre. En sortie du détecteur de crête, le signal Y(t) a une amplitude proportionnelle à l'amplitude de l'impulsion d'entrée (|Y(t)|=k Am), donc à l'énergie du photon.

Entre des instants t1 à t2, le signal de sortie est maintenu constant, permettant sa sauvegarde dans un système d'acquisition. A partir de l'instant t2, l'interrupteur SW2 se ferme : le détecteur est remis à zéro et le système peut traiter un nouveau photon.

Ce type d'intégrateur commuté est utilisé dans les chaînes de spectrométrie rapide à fort taux de comptage, c'est-à-dire dans les circuits électroniques de spectrométrie adaptés à des détecteurs soumis à un rayonnement intense et produisant de nombreuses impulsions par unité de temps, ou fort taux de comptage. On considère généralement qu'un taux de comptage est fort au delà de quelques 100 000 photons détectés par secondes (ou coups par secondes). Les intégrateurs précédemment décrits peuvent être utilisés jusqu'à quelques Megaphotons/s. Pour des taux de comptage encore plus élevés, l'emploi de ce type d'intégrateur devient difficile, notamment à cause des interrupteurs SWI et SW2, les temps de réponses (délai de commutation entre la commande et la sortie analogique) de SWI et SW2 ne permettant alors plus une intégration complète du signal Vs(t), entrainant ainsi une erreur sur la mesure de l'énergie du photon. Par ailleurs, la résistance de l'interrupteur SW2 à l'état passant intervient dans le temps de remise à zéro de l'intégrateur, ce qui contribue également à ralentir la chaîne de mesures.

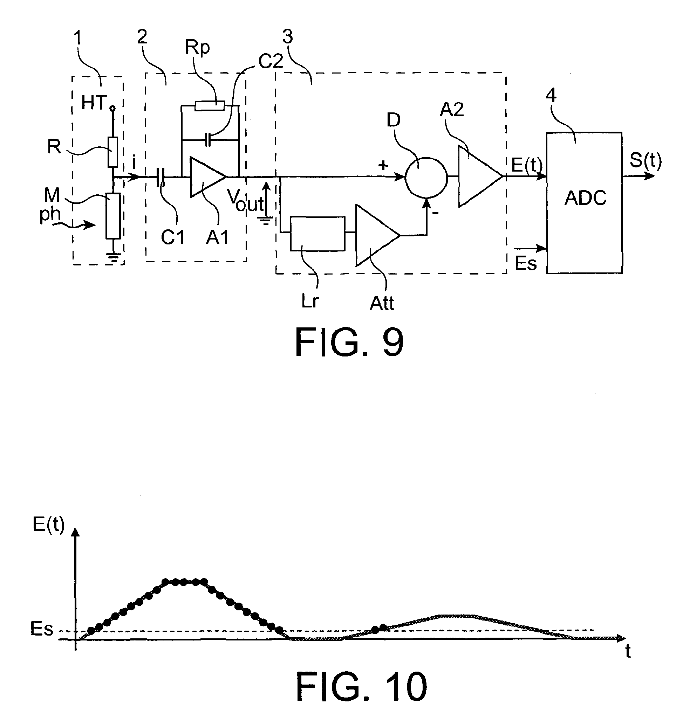

Pour pouvoir réaliser correctement des mesures par spectrométrie lorsqu'un détecteur est soumis à de forts taux de comptage une autre solution existe dans l'état de l'art. Il s'agit de la mesure de l'énergie des photons à l'aide d'une ligne à retard. La figure 9 représente un système de comptage qui utilise une ligne à retard. Un tel système n'utilise pas de circuit de filtrage et la sortie du préamplificateur de charges 2 est ici directement reliée à un ensemble constitué d'une ligne à retard Lr, d'un atténuateur Att (gain inférieur à 1), d'un soustracteur D, d'un amplificateur A2 et d'un circuit de conversion analogique/numérique ADC. La ligne à retard Lr est montée en série avec l'atténuateur Att et forme un bloc de retard et d'atténuation dont une première borne est reliée à la sortie du préamplificateur et la deuxième borne est reliée à une première entrée du soustracteur D dont la deuxième entrée est directement reliée à la sortie du préamplificateur.

Le signal $V_{OUT}(t)$ issu du préamplificateur est retardé à travers la ligne à retard Lr dont le délai est supérieur au temps de montée du signal $V_{OUT}(t)$. Le soustracteur D soustrait la tension $V_{OUT}(t)$ retardée et atténuée à la tension $V_{OUT}(t)$ et le signal qui résulte de cette soustraction est amplifié par l'amplificateur A2 qui délivre alors, via l'amplificateur A2, une impulsion E(t) dont la hauteur est proportionnelle à l'impulsion produite aux bornes du détecteur, c'est-à-dire à l'énergie cédée par le photon détecté dans le matériau détecteur. La numérisation qu'effectue le convertisseur analogique/numérique ADC est effectuée en permanence, le calculateur étant programmé pour repérer les valeurs d'énergie supérieures à un seuil d'énergie prédéterminée $E_S$. Une fois les valeurs d'énergie repérées, des algorithmes plus ou moins élaborés calculent les valeurs correspondantes d'énergie des photons. La figure 10 représente un exemple de courbe d'énergie détectée E(t) en fonction du temps. Les points répartis sur la courbes E(t) illustrent de manière symbolique la numérisation du signal E (t) qui est effectuée par le convertisseur analogique/numérique ADC.

L'émission des photons obtenus avec un générateur de rayon X ou une source radioactive est une émission aléatoire. Il est alors nécessaire de traiter les coïncidences, c'est-à-dire les périodes de temps ou de nombreux photons sont émis dans un intervalle de temps très court, contribuant ainsi à un empilement de signaux en entrée du circuit de conversion analogique/numérique. On précise que plus le rayonnement auquel le détecteur est soumis et intense, plus la probabilité de telles coïncidences est importante.

De nombreux traitements des coïncidences sont connus. Un des plus simples consiste à mesurer la largeur de l'impulsion (temps entre deux franchissements de seuil successifs) et de comparer cette valeur à une durée de référence. Si l'impulsion est trop longue, c'est qu'il y a empilement et la valeur d'énergie mesurée n'est pas prise en compte et l'impulsion est rejetée. On attend alors le photon suivant. Ce mode de traitement présente l'inconvénient d'être très peu efficace, notamment lorsque le taux de comptage est élevé, cas dans lequel il y a de nombreux empilements la plupart des impulsions ont alors une durée excédant la durée de référence, et elles sont rejetées. Ainsi, l'efficacité du système devient médiocre, une telle efficacité représentant un ratio entre le nombre d'impulsions traitées et le nombre d'impulsions détectées. Un exemple pour un tel dispositif est donné dans le document US 2003/0086 523 A1.

Il est également connu de l'art antérieur un dispositif pour réaliser le traitement et la numérisation d'un spectre en énergie d'un rayonnement électromagnétique tel que le dispositif divulgué dans la demande de brevet EP 2 071 722 publiée le 17 juin 2009. Ce dispositif comprend un circuit de préamplification, un circuit de mesure d'impulsions à ligne à retard, un échantillonneur, un circuit de mesure d'impulsions de courant réalisant la différence entre le signal pris en sortie du circuit de préamplification et une dérivée du signal pris en sortie du circuit de préamplification, et un circuit de discrimination réalisant un signal binaire en fonction du signal pris en sortie du circuit de mesure d'impulsions de courant, ledit signal binaire commandant les instants d'échantillonnage de l'échantillonneur. Ce dispositif permet de corriger les problèmes de détection liés au caractère aléatoire de l'échantillonnage et de la génération des charges dans les systèmes de détection de spectrométrie de rayonnement électromagnétique ionisant.

Exposé de l'invention

L'invention concerne un dispositif de traitement d'un signal délivré par un détecteur de rayonnement, le dispositif comprenant un premier circuit apte à délivrer une impulsion en tension dont l'amplitude est proportionnelle à une charge détectée par le détecteur et un convertisseur analogique/numérique qui numérise l'impulsion en tension à une fréquence d'échantillonnage donnée et délivre un signal numérique, caractérisé en ce qu'il comprend, en aval du convertisseur analogique/numérique, un circuit de traitement qui comprend :

- une unité de lecture du signal numérique délivré par le convertisseur analogique/numérique,
- une unité de calcul qui calcule un taux de variation temporelle du signal numérique lu, et
- un circuit de capture, piloté par ladite unité de calcul, apte à capturer le signal numérique lu lorsque le taux de variation temporelle atteint un seuil prédéterminé.

En aval du circuit de traitement, des moyens permettant d'obtenir un spectre en amplitude des signaux capturés par le circuit de capture.

Selon un mode de réalisation préféré, le dispositif de l'invention comprend, en amont de l'unité de calcul, un circuit de soustraction, apte à réaliser une soustraction de deux signaux temporellement décalés.

Selon une première variante, le circuit de soustraction est situé en amont du convertisseur analogique numérique, et en aval du préamplificateur relié au détecteur. Le circuit de soustraction génère un signal combinant le signal délivré par le préamplificateur à un instant t et le signal délivré par le même préamplificateur à un instant t - Δt.

L'invention concerne également un système de détection de rayonnement qui comprend un détecteur de rayonnement et un dispositif de traitement du signal délivré par le détecteur conforme à l'invention.

L'objet de la présente invention est de proposer un dispositif électronique qui permet, de façon simple et efficace, de mesurer, à partir des impulsions de courant issues d'un détecteur, l'énergie des photons incidents dans un temps très court qui garantit un taux de comptage très élevé et une très grande précision.

Brève description des figures

D'autres caractéristiques et avantages de l'invention apparaîtront à la lecture d'un mode de réalisation préférentiel fait en référence aux figures jointes, parmi lesquelles :

- la figure 1 représente le synoptique d'un système de détection de rayonnement de l'art antérieur
- la figure 2 représente un premier circuit électronique qui participe au système de détection de la figure 1 ;
- les figures 3 et 4 représentent des grandeurs électriques caractéristiques du circuit de la figure 2 ;
- la figure 5 représente la variation en fonction du temps d'une tension délivrée par un circuit électronique de traitement qui participe au système de détection de la figure 1 ;
- la figure 6 représente un circuit intégrateur actif commuté apte à participer au système de détection de la figure 1 ;
- les figures 7 et 8 représentent des signaux électriques caractéristiques du circuit de la figure 6;
- la figure 9 représente un synoptique d'un système de détection de rayonnement de l'art antérieur qui utilise une ligne à retard ;
- La figure 10 représente un exemple de courbe d'énergie détectée par le système de détection représenté en figure 9 ;
- La figure 11 représente un dispositif de détection de spectrométrie de rayonnement électromagnétique ionisant selon le mode de réalisation préférentiel de l'invention;
- la figure 12 représente une vue détaillée d'un circuit du dispositif de détection de l'invention représenté en figure 11 ;
- les figures 13 et 14 représentent des signaux électriques caractéristiques du circuit représenté en figure 12 ;
- la figure 15 représente un perfectionnement du circuit représenté en figure 12 ;
- les figures 16A et 16B représentent des signaux électriques caractéristiques du circuit de la figure 12 qui illustrent le fonctionnement du dispositif de l'invention en présence de nombreux empilements ; et
- les figures 17A et 17B représentent des signaux électriques caractéristiques du circuit de la figure 12 qui illustrent le traitement des coïncidences et des temps morts mis en oeuvre dans le dispositif de l'invention.

Sur toutes les figures, les mêmes références désignent les mêmes éléments.

Exposé détaillé de modes de réalisation préférentiels de l'invention.

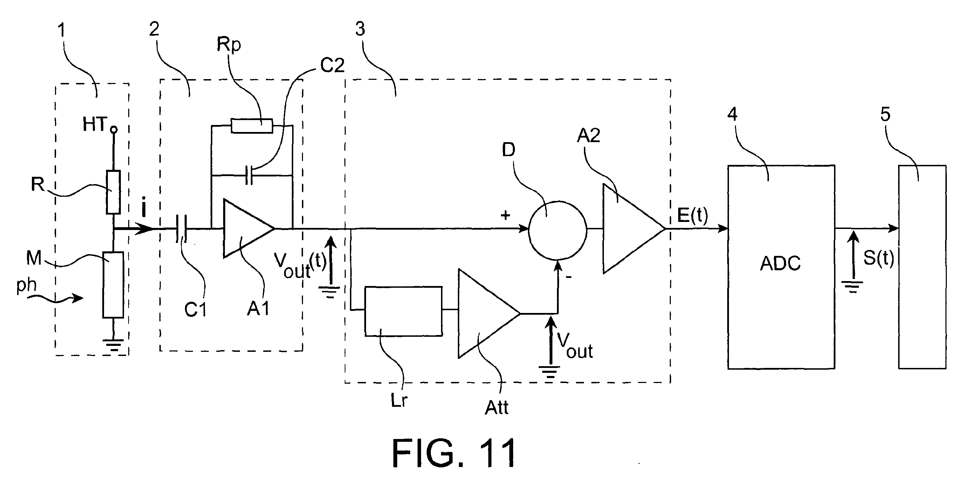

La figure 11 représente un dispositif de détection de spectrométrie de rayonnement électromagnétique ionisant selon le mode de réalisation préférentiel de l'invention.

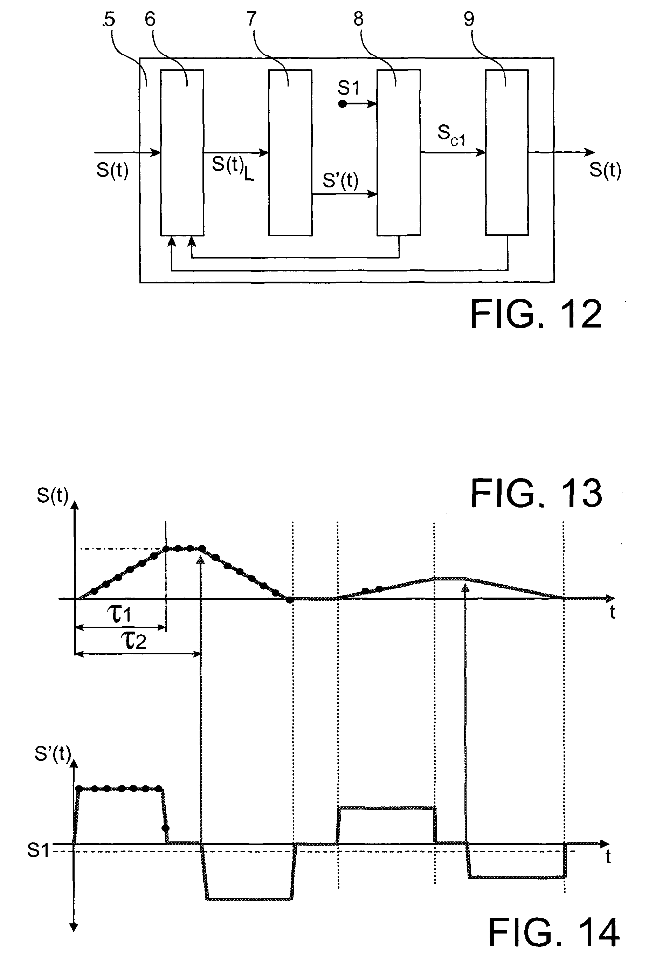

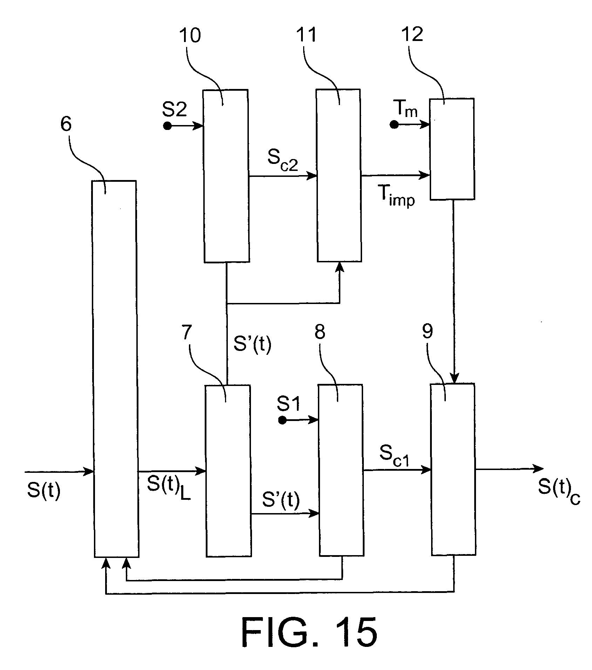

Selon le mode de réalisation préférentiel de l'invention, le dispositif comprend, outre l'ensemble des éléments mentionnés en référence au circuit d'art antérieur représenté en figure 9 (détecteur 1, préamplificateur de charges 2, circuit de soustraction 3, convertisseur analogique numérique 4), un circuit de traitement 5, qui opère un traitement des signaux numériques S(t) délivrés par le convertisseur analogique/numérique ADC. La figure 12 représente explicitement les unités de traitement du circuit 5 qui opèrent dans le cadre de l'invention. La figure 15 représente un perfectionnement du circuit de la figure 12. Le circuit de traitement 5 peut être, par exemple, un microprocesseur, un circuit logique programmable (FPGA en langue anglaise pour «Field Programmable Gate Array»), ou un circuit intégré spécifique (circuit ASIC pour « Application Specific Integrated Circuit »).

Le circuit de traitement 5 permet de sélectionner certains signaux numériques, les signaux numériques sélectionnés étant alors destinés à être traités par des équipements standards disposés en aval de ce circuit. Ces équipements standards peuvent, par exemple, comprendre des moyens permettant de réaliser un spectre en amplitude des signaux numériques capturés. Un tel spectre correspond à un histogramme des signaux capturés, en fonction de leur amplitude. De tels moyens de spectrométrie peuvent par exemple comprendre un analyseur multicanal. Seuls les signaux capturés sont considérés par l'analyseur multicanal situé en aval du circuit de capture. Autrement dit, le circuit de traitement 5 réalise un tri des signaux numériques, seuls les signaux dits capturés étant alors traités par les moyens de spectrométrie.

Par capture d'un signal, on entend la transmission du signal vers des moyens électroniques disposés en aval du circuit de capture, les signaux non capturés n'étant pas transmis vers ces moyens.

Le préamplificateur de charges 2 et le circuit de soustraction 3 constituent un circuit qui est nommé « premier circuit » dans la présente demande de brevet.

Selon le mode de réalisation préférentiel de l'invention, le premier circuit (2,3) qui délivre une impulsion analogique utilise une ligne à retard et un soustracteur, ce qui permet avantageusement d'obtenir une impulsion dont les caractéristiques temporelles (temps de montée, temps de descente) sont proches de l'impulsion collectée par l'électrode du détecteur. L'utilisation d'un circuit à ligne à retard permet ainsi d'obtenir une information temporelle précise.

Le circuit soustracteur 3 est placé entre la sortie du préamplificateur de charges 2 et le convertisseur analogique numérique 4. Ce circuit permet d'effectuer une soustraction entre :

- le signal analogique V(t) délivré par le préamplificateur à l'instant t, et
- un signal analogique V'(t), délivré par un circuit à ligne à retard au même instant, et dépendant du signal analogique V(t-Δt).

Ainsi, le signal V'(t) est-il une image du signal V(t - Δt), Δt correspondant au décalage temporel produit par la ligne à retard. Par exemple, on peut avoir :

$$V'(t) = V(t - \Delta t)$$

ou, d'une façon plus générale :

$$V'(t) = a\, V(t - \Delta t),$$

a étant un réel.

Le circuit à ligne à retard peut comprendre un atténuateur, de sorte que :

$$V'(t) \leq V(t - \Delta t)$$

Ainsi, le circuit de soustraction 3 permet-il d'obtenir un signal de sortie E(t) tel que :

$$E(t) = V(t) - V'(t),$$

dont les caractéristiques temporelles sont proches de celles de l'impulsion détectée aux bornes du détecteur. De façon connue en soi de l'homme du métier, le décalage temporel Δt est choisi supérieur ou égal au temps de montée de l'impulsion V(t) générée par le préamplificateur. Ainsi, lors de la détection d'une interaction par le détecteur, c'est-à-dire lorsque le détecteur génère une impulsion, le signal E(t) généré par le circuit de soustraction 3 décrit-il une impulsion dont l'amplitude est proportionnelle à l'amplitude du courant détecteur, comme on peut le voir dans la demande EP 2 071 722 précédemment citée.

On pourrait également disposer le circuit de soustraction 3 en aval du convertisseur analogique numérique 4, mais alors, toujours en amont d'une unité de capture 9 qui sera décrite ultérieurement. Cela nécessite alors des convertisseurs analogiques numériques de dynamique élevée (de préférence supérieure à 8 bits, voire supérieure à 12 bits), avec une fréquence d'échantillonnage de l'ordre de 100 MHz.

L'invention concerne également d'autres types de « premier circuit » aptes à délivrer une impulsion analogique dont l'amplitude est proportionnelle à l'amplitude produite aux bornes du détecteur, par exemple un filtre d'impulsion tel que celui précédemment décrit. De même que dans l'art antérieur, cette impulsion analogique est ensuite numérisée par un convertisseur analogique numérique ADC, de façon à produire un ensemble de signaux numérisés, également appelés signaux numériques, S(t), prenant la forme d'une impulsion numérisée. Ainsi, une impulsion numérisée rassemble-t-elle l'ensemble des signaux numériques S(t) produits par le traitement de l'impulsion analogique par le convertisseur analogique numérique, l'impulsion analogique correspondant à une interaction détectée par le détecteur.

La figure 12 représente les unités constituant le circuit de traitement 5. Le circuit de traitement 5 comprend une unité 6 de lecture du signal numérisé S(t) délivré par le convertisseur analogique/numérique ADC, une unité 7 de calcul du taux de variation temporelle S' (t) entre deux signaux numériques successifs lus, une unité 8 de comparaison du taux de variation temporelle S'(t) délivré par l'unité 7 avec un seuil de variation S1 prédéterminé et une unité de capture 9 apte à capturer ou non le signal numérique lu.

L'unité 6 de lecture lit, selon une fréquence de lecture, le signal S(t) numérisé délivré par le convertisseur analogique/numérique ADC. De préférence, la fréquence de lecture est égale à la fréquence d'échantillonnage du convertisseur analogique numérique et l'unité de lecture et le convertisseur analogique numérique sont synchronisés par la même horloge. A la différence du dispositif divulgué dans le document EP 2 071 722, la fréquence d'échantillonnage du convertisseur analogique numérique est fixe, ce qui permet l'utilisation d'un convertisseur synchronisé selon une fréquence d'échantillonnage élevé et qui s'avère particulièrement utile en fort taux de comptage. On utilisera de préférence un convertisseur de type "pipeline", bien connu de l' homme du métier. Dans le document EP 2 071 722, la fréquence d'échantillonnage n'est pas constante : les instants d'échantillonnage sont déterminés par un module du circuit, ce qui contraint à l'utilisation de convertisseurs asynchrones, connus pour leur taux d'échantillonnage plus faible, de tels convertisseurs étant alors moins adaptés aux forts taux de comptage.

La figure 13 représente un exemple de signal numérique délivré par le convertisseur analogique/numérique ADC lors de la détection de deux interactions successives, correspondant aux deux impulsions de signal numérisé visibles sur cette figure. Le signal délivré par le convertisseur analogique/numérique ADC est numérisé en permanence, par exemple à une fréquence élevée comprise entre 1 MHz et 1 GHz (typiquement quelques centaines de MHz). Le temps $\tau$1 indiqué sur le première impulsion de signal numérisé de la figure 13 correspond au temps de montée de l'impulsion de courant collectée par l'électrode du détecteur (temps de transit des charges dans le détecteur) et le temps $\tau$2 correspond à la durée entre le début de cette impulsion de courant et sa décroissance ($\tau$2 peut ainsi correspondre, en première approximation, au temps mort du système de spectrométrie utilisé : il s'agit du délai imposé par la ligne à retard précédemment évoquée). L'unité 6 de lecture délivre un signal numérique lu $S(t)_L$. L'unité 7 de calcul de taux de variation temporelle détermine alors le taux de variation S'(t) sous la forme de l'équation (1) ci-dessous :

$$S'(t) = [S(t)_L - S(t-dt)_L]/dt \quad (1)$$

Ainsi, un taux de variation S'(t) peut être calculé à chaque nouvelle impulsion lue $S(t)_L$, c'est-à-dire à la fréquence de lecture.

La figure 14 illustre, à titre d'exemple, le signal numérique délivré par l'unité de calcul de taux de variation temporelle lorsque le signal numérique délivré par le convertisseur ADC est conforme au signal représenté en figure 13. Le taux de variation S'(t) délivré par l'unité 7 est comparé au seuil S1 par l'unité de comparaison 8. Lors de chaque impulsion de signal numérisé, le signal S'(t) prend successivement des valeurs positives et négatives. Le seuil S1 est placé à une valeur négative prédéterminée. La valeur absolue du seuil S1 est supérieure au niveau de bruit BS' (t) affectant le taux de variation S'(t). En effet, bien que cela ne soit pas représenté sur les figures, les valeurs du taux de variation S'(t) sont affectées de fluctuations haute fréquence dues au bruit $BS(t)_L$ affectant le signal numérique lu $S(t)_L$. Le bruit BS'(t) affectant le signal S'(t) est généralement de valeur moyenne nulle. On détermine alors le seuil S1 en fonction de ce bruit BS'(t), de telle sorte que S1 soit inférieur à l'amplitude négative maximale du bruit BS'(t). De plus, S1 sera choisi de telle sorte que sa valeur absolue soit suffisamment faible, afin qu'à l'instant $t_0$ auquel $S'(t_0)$ franchit le seuil S1, le signal numérique $S(t_0)_L$ soit le plus proche possible de la valeur maximum de l'impulsion, afin que la valeur capturée représente l'amplitude maximale de cette impulsion. Par proche, on entend quelques périodes de lecture, une période de lecture dt correspondant à l'inverse de la fréquence de lecture.

L'étape d'ajustement du seuil S1 est réalisée expérimentalement et peut être renouvelée, de telle sorte que la valeur du seuil S1 puisse être rafraîchie.

Selon ce mode de réalisation, une interaction détectée correspond à des valeurs positives de $S(t)_L$, formant une impulsion. Dans ce cas, l'instant de capture $t_0$ correspond au moment ou :

$$S'(t0) \leq S1, \text{ avec } S'(t_0 - \delta t) > S1.$$

Autrement dit, le taux de variation S'(t) est une fonction décroissante lorsque le signal S'(t) franchit S1.

Le signal de comparaison $S_{c1}$ délivré par l'unité de comparaison 8 commande l'unité de capture 9. Si le seuil S1 n'est pas franchi (i.e. S1 ≤ S' (t)) , le signal de comparaison commande l'unité de capture 9 à ne pas capturer le dernier signal numérisé lu. Sinon (seuil franchi, i.e. S'(t) ≤ S1), le signal de comparaison commande l'unité de capture à capturer le dernier signal numérisé lu.

On voit que pour une même impulsion de signal numérisé, correspondant aux signaux S(t) issus de la numérisation d'une même impulsion analogique, le taux de variation S'(t) décrit successivement une première partie, correspondant à la croissance en amplitude des signaux $S(t)_L$, puis une seconde partie, correspondant à la décroissance en amplitude des signaux $S(t)_L$. Dans le cas présent, la première partie est appelée partie positive et la seconde partie est appelée partie négative. La partie positive du signal S'(t) correspond à l'image du courant photonique produit par l'interaction d'un photon dans le détecteur. La partie négative du signal S'(t) est utilisée pour la synchronisation : dès que cette partie négative est inférieure au seuil S1, la valeur correspondante du signal S(t) est retenue, ou capturée, pour la formation du spectre. De façon avantageuse, le dispositif de l'invention présente une meilleure discrimination des interactions coïncidentes que la discrimination qui est obtenue par les circuits de l'art antérieur. Le fait de travailler sur la variation temporelle du signal présent en aval de la ligne à retard comporte un avantage par rapport au fait de travailler sur la variation temporelle du signal présent en amont de cette ligne. En effet, on bénéficie alors de l'effet de filtrage de la ligne à retard, le rapport signal sur bruit du signal présent en sortie de la ligne à retard étant meilleur que celui existant en entrée de la ligne. L'information temporelle obtenue est plus précise. De plus, par rapport au dispositif décrit dans le brevet EP 2 071 022, outre l'avantage précédemment cité, le dispositif selon l'invention nécessite moins de composants, ce qui rend sa réalisation plus simple et économique.

La figure 15 représente un perfectionnement du circuit représenté en figure 12. Selon ce perfectionnement, le dispositif comprend des moyens aptes à déterminer une durée de la partie positive du signal S'(t). En effet, lorsque S'(t) atteint la valeur S1 correspondant à l'instant de capture $t_0$ précédemment décrit, mais que la partie positive de S'(t) dépasse une durée prédéterminée $T_m$, la capture n'est pas réalisée. Par partie positive de S'(t) on entend l'ensemble des signaux S'(t), correspondant à la croissance en amplitude des signaux $S(t)_L$ correspondant à la même impulsion analogique numérisée.

Outre les circuits 6, 7, 8 et 9 mentionnés précédemment, le circuit 5 comprend une unité de comparaison de signal 10, une unité de comptage 11 de la durée $T_{imp}$ de la partie positive de S'(t) et une unité de comparaison 12 de cette durée $T_{imp}$. Le signal S'(t) est tout d'abord comparé avec une valeur de seuil S2. La valeur de seuil S2 est ajustée expérimentalement, en fonction du bruit BS'(t) affectant le signal S'(t). On fixe S2 de telle sorte que sa valeur soit de signe opposé à S1 et que sa valeur absolue soit supérieure à l'amplitude maximum du bruit BS'(t). Elle peut être de valeur opposée à S1, c'est-à-dire de même valeur absolue, mais de signe opposé. Lorsque le signal S'(t) est supérieur à S2, le comparateur 10 délivre un signal $S_{c2}$ qui commande le comptage de la durée d'impulsion $T_{imp}$, sinon il n'y a pas de comptage. Il y a incrémentation du compteur de durée d'impulsion pour chaque valeur lue de S'(t) jusqu'à ce qu'un signal lu S'(t) redevienne inférieur à S2, ce qui arrête le comptage. La durée $T_{imp}$ de la partie positive de l'impulsion S'(t) délivrée par l'unité de comptage 11 est alors comparée à une valeur de seuil de durée $T_m$. La durée $T_m$ est préférentiellement choisie comme étant le temps de montée du signal pris en sortie du préamplificateur de charges. Si la durée $T_{imp}$ de la partie positive de l'impulsion S'(t) est supérieure à $T_m$, le signal délivré par le comparateur 12 commande l'unité de capture 9 pour ne pas capturer le signal $S(t_0)_L$, correspondant à l'instant $t_0$ auquel S'(t) passe en dessous du seuil S1 comme précédemment décrit. Si la durée d'impulsion $T_{imp}$ est inférieure ou égale à $T_m$, le signal $S(t_0)_L$ correspondant à l'instant $t_0$ tel que $S'(t_0) \leq S1$ et $S'(t0 - \delta t) > S1$, $\delta t$ étant la période de l'horloge de synchronisation du circuit de lecture, est pris en compte.

On s'est placé jusqu'à présent dans le cas où une interaction détectée produit une impulsion positive du signal numérisé, c'est-à-dire que les signaux $S_L$ lus pendant l'interaction sont positifs. Naturellement, on comprendra que l'invention précédemment décrite s'applique également si une interaction produit une impulsion négative du signal numérisé et lu, c'est-à-dire que durant l'interaction, les signaux $S(t)_L$ sont négatifs, le seuil S1 sera positif, et la capture sera réalisée à l'instant $t_o$ ou $S'(t_o)$ franchit le seuil S1 en étant croissante. Autrement dit, l'instant de capture to est tel que $S'(t_o) \geq S1$ et $S'(t_0 -dt) < S1$. Toujours selon ce cas, le seuil S2 sera négatif.

Le dispositif de l'invention, lorsqu'il est disposé en amont de moyens de spectrométrie, tels que ceux précédemment évoqués, autorise avantageusement des mesures spectrométriques sous flux élevé. Le dispositif de l'invention permet en effet d'extraire les valeurs utilisées pour la construction du spectre même en présence de nombreux empilements d'impulsions mises en forme par la ligne à retard.

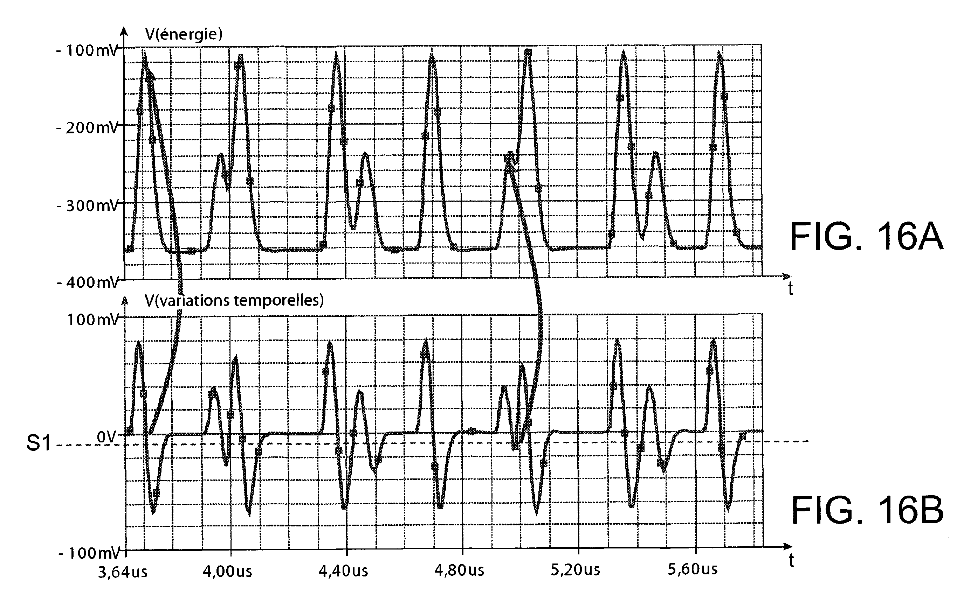

Les figures 16A et 16B illustrent cet avantage de l'invention. La figure 16A représente des impulsions de tension obtenues en présence de nombreux empilements et la figure 16B représente les variations temporelles des empilements de tension représentés en figure 16A. Le franchissement du seuil S1 par les variations temporelles de signal (cf. figure 16B) donne un repère temporel pour déclencher une sauvegarde dans le spectre du signal. Dès que la variation temporelle est inférieure au seuil S1 (cf. figure 16B), la valeur correspondante du signal (cf. figure 16A) est repérée et sauvegardée pour le montage du spectre. Contrairement aux méthodes de l'art antérieur, il est alors toujours possible d'extraire des mesures correctes, même en cas de superposition des impulsions. Le dispositif de l'invention permet ainsi de pousser les performances de systèmes de mise en forme d'impulsions au maximum de leurs performances en taux de comptage.

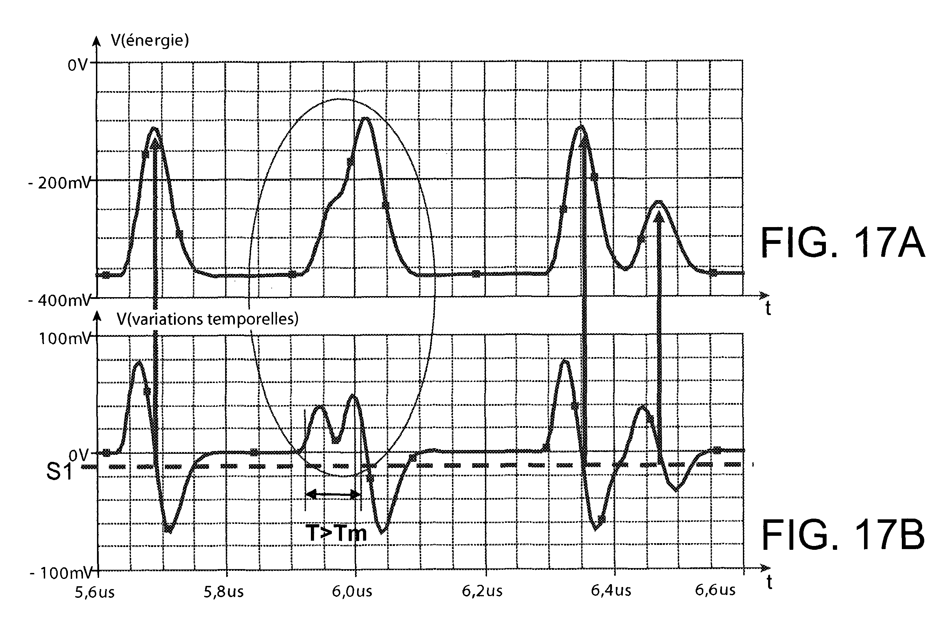

Les figures 17A et 17B illustrent les avantages qui résultent du perfectionnement du dispositif de l'invention représenté en figure 15. Dans le cas où la durée de la partie positive de la variation temporelle du signal est plus longue que le temps de référence $T_m$, c'est qu'il y a empilement. La valeur de l'énergie détectée est alors fausse et il ne faut pas la faire apparaître dans le spectre d'énergie. Les figures 17A et 17B illustrent le cas où deux photons interagissent dans le détecteur dans un temps très court. La variation temporelle du signal ne franchit alors pas le seuil S1 et la durée de la partie positive de la variation temporelle est supérieure à $T_m$. Les deux photons ne sont pas donc retenus pour le spectre. Le temps mort du dispositif à ligne à retard de l'invention est le temps nécessaire pour mesurer l'énergie d'un photon qui interagit dans le détecteur, c'est-à-dire le délai $T_d$ imposé par la ligne à retard. Une condition à respecter dans le dispositif de l'invention est alors que le délai $T_d$ soit supérieur ou égal à la durée $T_m$.

Le dispositif tel que décrit dans cette invention trouvera des applications nécessitant de réaliser une mesure par spectrométrie de tout rayonnement ionisant, et tout particulièrement le rayonnement X ou le rayonnement gamma, et notamment dans les cas ou ledit rayonnement est intense.

Outre le contrôle de bagage, ce dispositif pourra trouver des applications dans le domaine nucléaire, par exemple la mesure de déchets ou de combustibles.

**Revendications**

1. Dispositif de traitement d'un signal délivré par un détecteur de rayonnement (1), le dispositif comprenant premier un circuit (2, 3) apte à délivrer une impulsion en tension dont l'amplitude est proportionnelle à une charge détectée par le détecteur (1) et un convertisseur analogique/numérique (ADC) qui numérise l'impulsion en tension et délivre des signaux numériques (S(t)), **caractérisé en ce qu'**il comprend, en aval du convertisseur analogique/numérique (ADC), un circuit de traitement (5) qui comprend :

   - une unité de lecture (6), des signaux numériques délivrées (S(t)) par le convertisseur analogique/numérique (ADC),
   - une unité de calcul (7) qui calcule un taux de variation temporelle (S'(t)) des signaux numériques lus (S(t)$_L$),
   - un circuit de capture (8, 9), commandé par l'unité de calcul (7) apte à capturer les signaux numériques lus lorsque le taux de variation temporelle (S'(t)) atteint un seuil prédéterminé (S1), et
   - en aval du circuit de traitement (5), des moyens permettant d'obtenir un spectre en amplitude des signaux capturés.

2. Dispositif selon la revendication I, dans lequel le circuit de traitement comprend, en outre, des moyens (10, II) aptes à déterminer une durée ($T_{imp}$) durant laquelle le taux de variation temporelle (S'(t)) est supérieur à un seuil d'amplitude (S2) de signe opposé au seuil prédéterminé (S1), et des moyens de comparaison (12) de ladite durée avec une valeur de seuil de durée ($T_m$), les moyens de comparaison (12) de la durée d'impulsion numérique délivrant un signal qui conditionne la capture de l'impulsion numérique lue de sorte qu'une impulsion numérique lue est capturée si, en outre, la durée durant laquelle le taux de variation temporelle (S'(t)) est supérieur au seuil d'amplitude (S2) est inférieure ou égale à la valeur de seuil de durée.

3. Dispositif selon la revendication 2, dans lequel les moyens (10, 1I) aptes à déterminer une durée ($T_{imp}$) durant laquelle le taux de variation temporelle (S'(t)) est supérieur à un seuil d'amplitude (S2), comprennent un compteur qui est incrémenté à chaque signal numérique lu, le comptage étant interrompu dès lors qu'une impulsion numérique lue a une amplitude inférieure au seuil d'amplitude (S2).

4. Dispositif selon la revendication 2, dans lequel la valeur de seuil de durée ($T_m$) est le temps de montée d'un signal pris en sortie d'un préamplificateur de charges placé en entrée du dispositif comprenant un circuit apte à délivrer une impulsion en tension dont l'amplitude est proportionnelle à une charge détectée par le détecteur.

5. Dispositif selon l'une quelconque des revendications 1 à 4, dans lequel le circuit apte à délivrer une impulsion en tension dont l'amplitude est proportionnelle à une charge détectée par le détecteur comprend un circuit de mesure d'énergie par ligne à retard (Lr, Att, D, A2).

6. Dispositif selon l'une quelconque des revendications précédentes, dans lequel la fréquence de d'échantillonnage du convertisseur analogique/numérique est supérieure à 100 KHz.

7. Dispositif selon l'une quelconque des revendications 1 à 6 dans lequel, le circuit de traitement (5) est un microprocesseur, ou un circuit logique programmable, ou un circuit intégré spécifique.

8. Système de détection de rayonnement comprenant un détecteur et un dispositif de traitement d'un signal délivré par le détecteur, **caractérisé en ce que** le dispositif de traitement est un dispositif selon l'une quelconque des revendications 1 à 6.

9. Système de détection de rayonnement selon la revendication 8, dans lequel le détecteur est un détecteur à semi-conducteur.

10. Système de détection de rayonnement selon la revendication 9, dans lequel le semi-conducteur est choisi parmi le CdZnTe, le CdTe: Cl, le CdTe:In.

**Patentansprüche**

1. Einrichtung zur Verarbeitung von einem Signal, das von einem Strahlungsdetektor (1) geliefert wird, wobei die Einrichtung einen ersten Schaltkreis (2, 3) umfasst, der dazu geeignet ist, einen Spannungspuls zu liefern, dessen Amplitude proportional zu einer von dem Detektor (1) erfassten Ladung ist, und einen Analog/Digital-Wandler (ADC) umfasst, der den Spannungspuls digitalisiert und digitale Signale (S(t)) liefert, **dadurch gekennzeichnet, dass** sie, dem Analog/Digital-Wandler nachgeschaltet, einen Verarbeitungsschaltkreis (5) umfasst, welcher umfasst:

   - eine Ausleseeinheit (6) für die digitalen Signale (S(t)), die durch den Analog/Digital-Wandler (ADC) geliefert werden,
   - eine Recheneinheit (7), die eine zeitliche Änderungsrate (S'(t)) der ausgelesenen digitalen Signale (S(t)$_L$) berechnet,
   - einen Erfassungsschaltkreis (8, 9), der durch die Recheneinheit (7) gesteuert/geregelt wird, und der dazu in der Lage ist, die ausgelesenen digitalen Signale zu erfassen, wenn die zeitliche Änderungsrate (S'(t)) einen vorbestimmten Schwellenwert (S1) erreicht, und
   - dem Verarbeitungsschaltkreis (5) nachgeschaltete Mittel, welche es ermöglichen, ein Amplituden-Spektrum der erfassten Signale zu erhalten.

2. Einrichtung nach Anspruch 1, wobei der Verarbeitungsschaltkreis weiterhin Mittel (10, 11) umfasst, die dazu geeignet sind, eine Dauer (T$_{imp}$) zu bestimmen, während der die zeitliche Änderungsrate (S'(t)) größer als ein Amplituden-Schwellenwert (S2) ist, mit umgekehrtem Vorzeichen zu dem vorbestimmten Schwellenwert (S1), und Mittel zum Vergleichen (12) der Dauer mit einem Dauer-Schwellenwert (T$_m$), wobei die Mittel zum Vergleichen (12) der Dauer des digitalen Pulses ein Signal liefern, das die Erfassung von dem ausgelesenen digitalen Puls zur Folge hat, so dass ein ausgelesener digitaler Puls erfasst wird, wenn weiterhin die Dauer, während der die zeitliche Änderungsrate (S'(t)) größer als der Amplituden-Schwellenwert (S2) ist, kleiner oder gleich dem Dauer-Schwellenwert ist.

3. Einrichtung nach Anspruch 2, wobei die Mittel (10, 11), die dazu geeignet sind, eine Dauer (T$_{imp}$) zu bestimmen, während der die zeitliche Änderungsrate (S'(t)) größer ein Amplituden-Schwellenwert (S2) ist, einen Zähler umfassen, der bei jedem ausgelesenen digitalen Signal inkrementiert wird, wobei das Zählen bei einem ausgelesenen digitalen Puls mit einer Amplitude, die kleiner als der Amplituden-Schwellenwert (S2) ist, unterbrochen wird.

4. Einrichtung nach Anspruch 2, wobei der Dauer-Schwellenwert (T$_m$) die Anstiegszeit von einem Signal ist, das am Ausgang von einem Ladung-Vorverstärker genommen wird, der am Eingang der Einrichtung positioniert ist, die einen Schaltkreis umfasst, der dazu geeignet ist, einen Spannungspuls zu liefern, dessen Amplitude proportional zu einer von dem Detektor erfassten Ladung ist.

5. Einrichtung nach einem der Ansprüche 1 bis 4, wobei der Schaltkreis, der dazu geeignet ist, einen Spannungspuls zu liefern, dessen Amplitude proportional zu einer von dem Detektor erfassten Ladung ist, einen Schaltkreis zur Energiemessung mit Verzögerungsleitung (Lr, Att, D, A2) umfasst

6. Einrichtung nach einem der vorhergehenden Ansprüche, wobei die Abtastfrequenz des Analog/Digital-Wandlers größer als 100 KHz ist.

7. Einrichtung nach einem der Ansprüche 1 bis 6, wobei der Verarbeitungsschaltkreis (5) ein Mikroprozessor oder ein programmierbarer Logik-Schaltkreis oder ein spezifischer integrierter Schaltkreis ist.

8. System zur Strahlungsdetektion, umfassend einen Detektor und eine Einrichtung zur Verarbeitung eines Signals, das von dem Detektor geliefert wird, **dadurch gekennzeichnet, dass** die Einrichtung zur Verarbeitung eine Einrichtung nach einem der Ansprüche 1 bis 6 ist.

9. System zur Strahlungsdetektion nach Anspruch 8, wobei der Detektor ein Halbleiter-Detektor ist.

10. System zur Strahlungsdetektion nach Anspruch 9, wobei der Halbleiter ausgewählt ist aus CdZnTe, CdTe:Cl, CdTe:In.

**Claims**

1. A device for processing a signal delivered by a radiation detector (1), the device comprising a first circuit (2, 3) able to deliver a voltage pulse whereof the amplitude is proportional to a charge detected by the detector (1) and an analog/digital converter (ADC) that digitizes the voltage pulse and delivers digital signals (S(t)), **characterized in that** it comprises, downstream of the analog/digital converter (ADC), a processing circuit (5) that comprises:

   - a reading unit (6), for reading the digital signals delivered (S(t)) by the analog/digital converter (ADC),
   - a computing unit (7) that computes a temporal variation rate (S'(t)) of the read digital signals (S(t)$_L$),
   - a capture circuit (8, 9), controlled by said computing unit (7), able to capture the read digital signals when the temporal variation rate (S'(t)) reaches a predetermined threshold (S1), and
   - downstream of the processing circuit (5), a means making it possible to obtain an amplitude spectrum of the captured signals.

2. The device according to claim 1, wherein the processing circuit also comprises means (10, 11) able to determine a duration ($T_{imp}$) during which the temporal variation rate (S'(t)) is above an amplitude threshold (S2) having a sign opposite the predetermined threshold (S1), and comparison means (12) for comparing said duration with a duration threshold value ($T_m$), the comparison means (12) of the digital pulse duration delivering a signal that conditions the capture of the read digital pulse such that a read digital pulse is captured if, moreover, the duration during which the temporal variation rate (S'(t)) is greater than the amplitude threshold (S2) is less than or equal to the duration threshold value.

3. The device according to claim 2, wherein the means (10, 11) able to determine a duration ($T_{imp}$) during which the temporal variation (S'(t)) is above an amplitude threshold (S2), comprise a counter that is incremented upon each read digital signal, the counting being interrupted once a read digital pulse has an amplitude below the amplitude threshold (S2).

4. The device according to claim 2, wherein the duration threshold value ($T_m$) is the rise time of an output signal of a charge preamplifier placed at the input of the device comprising a circuit able to deliver a voltage pulse whereof the amplitude is proportional to a charge detected by the detector.

5. The device according to any claim 1 to 4, wherein the circuit able to deliver a voltage pulse whereof the amplitude is proportional to a charge detected by the detector comprises an energy measurement circuit with each delay line (Lr, Att, D, A2).

6. The device according to any preceding claim, wherein the sampling frequency of the analog/digital converter is greater than 100 KHz.

7. The device according to any preceding claim, wherein the processing circuit (5) is a microprocessor, or a programmable logic circuit, or a specific integrated circuit.

8. A radiation detection system comprising a detector and a device for processing a signal delivered by the detector, **characterized in that** the processing device is a device according to any one of claims 1 to 6.

9. The radiation detection system according to claim 8, wherein the detector is a semiconductor detector.

10. The radiation detection system according to claim 9, wherein the semiconductor is chosen among CdZnTe, CdTe:Cl, CdTe:In.

# FIG. 1

# FIG. 2

FIG. 3

FIG. 4

FIG. 5

FIG. 6

FIG. 7

FIG. 8

FIG. 9

FIG. 10

FIG. 11

EP 2 484 011 B1

## FIG. 12

S(t) → [5, 6] → S(t)$_L$ → [7] → S'(t) → [8] → S$_{c1}$ → [9] → S(t)

S1 → [8]

## FIG. 13

S(t)

$\tau_1$
$\tau_2$

t

## FIG. 14

S'(t)

S1

t

FIG. 15

FIG. 16A

FIG. 16B

EP 2 484 011 B1

FIG. 17A

FIG. 17B

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20030086523 A1
- EP 2071722 A

- EP 2071022 A